# EUROPÄISCHE PATENTSCHRIFT

(11) **EP 4 264 289 B1**
(45) Veröffentlichungstag und Bekanntmachung des Hinweises auf die Patenterteilung: **01.01.2025**
(21) Anmeldenummer: 21839902.0
(22) Anmeldetag: 15.12.2021
(51) Int. Cl.: G01R 13/02

(54) **MESSUNG EINER FOLGE VON WIEDERKEHRENDEN ELEKTRONISCHEN SIGNALEN**
MEASUREMENT OF A SEQUENCE OF RECURRING ELECTRONIC SIGNALS
MESURE D'UNE SÉQUENCE DE SIGNAUX ÉLECTRONIQUES PÉRIODIQUES

(30) Priorität: 15.12.2020 DE 102020133467
(43) Veröffentlichungstag der Anmeldung: 25.10.2023
(73) Patentinhaber: Fraunhofer-Gesellschaft zur Förderung der angewandten Forschung e.V., 80686 München (DE); Friedrich-Schiller-Universität Jena, 07743 Jena (DE)
(72) Erfinder: EILENBERGER, Falk, 07745 Jena (DE); VOGL, Tobias, 07749 Jena (DE)
(74) Vertreter: Louis Pöhlau Lohrentz
(86) Internationale Anmeldenummer: PCT/EP2021/085894
(87) Internationale Veröffentlichungsnummer: WO 2022/129173

(56) Entgegenhaltungen:
- US-A1- 2016 365 868
- US-A1- 2018 299 491
- US-A1- 2019 277 887
- US-B1- 8 024 142

## Beschreibung

Die Erfindung betrifft ein Verfahren zur Messung einer Folge von wiederkehrenden elektronischen Signalen nach den Merkmalen des Oberbegriffs des Anspruchs 1 und eine Vorrichtung zur Messung einer Folge von wiederkehrenden elektronischen Signalen nach den Merkmalen des Oberbegriffs des Anspruchs 14.

Das präzise Messen von elektrischen Signalen ist eine der grundlegenden Aufgaben in der Physik, Elektrotechnik oder Nachrichtentechnik, wobei dafür unter anderem digitale Oszilloskope (DSO Digital Storage Oscilloscopes) verwendet werden. Ein digitales Oszilloskop tastet das zu messende elektrische Signal durch einen Analog-Digital-Wandler (A/D, oder A/D Wandler, oder ADC analog-to-digital converter) ab. Das Abtasten, d.h. das Messen der Spannung erfolgt dabei in zeitlich diskreten Intervallen der sogenannten Abtastrate, welche durch den Analog-Digital-Wandler vorgegeben werden. Mit der durch die Abtastrate vorgegebene Auflösung wandelt der Analog-Digital-Wandler das analoge elektrische Signal mit kontinuierlicher Zeit und kontinuierlicher Amplitude (Spannung) in ein digitales Signal mit diskreter Zeit (vorgegeben durch die Abtastrate) und diskreter Amplitude (gemessene Spannung) um.

Digitale Oszilloskope können in zwei Kategorien eingeteilt werden: sogenannte Echtzeit-Oszilloskope und Sampling-Oszilloskope.

Bei einem Echtzeit-Oszilloskop wird das Signal mit meist äquidistanten Zeitabständen abgetastet und digitalisiert. Bei bekannten Oszilloskopen ist die Abtastrate relativ groß. Dabei ist es notwendig, dass die Abtastrate deutlich kürzer ist als die Periode des Signals, wodurch bei Signalen mit hoher Frequenz ein sehr schneller Analog-zu-Digital-Wandler (ADC) benötigt wird. Ein Echtzeit-Oszilloskop hat den Vorteil, dass bereits aus einem einzigen Puls das Signal rekonstruiert werden kann.

Bei einem Sampling-Oszilloskop wird pro Trigger-Zyklus, d.h. pro Signal meist nur ein Spannungswert digitalisiert. Dazu wird der Abtastzeitpunkt vom Trigger-Signal aus bei jedem Signal-Zyklus um eine Zeiteinheit (welche die Abtastrate vorgibt) verschoben. Damit ist es möglich, nach mehreren Zyklen das Signal eines wiederkehrenden Pulses zu rekonstruieren. Schnelle Pulsfluktuationen können aber von einem Sampling-Oszilloskop nicht erkannt werden.

US 2018/299491 A1 beschreibt ein Sampling-Oscilloskop.

Die Auflösung eines Oszilloskops wird durch die Bandbreite *f_{bw}* angegeben und sollte für präzise Zeitmessungen mindestens doppelt so groß sein wie die höchste Frequenzkomponente des Signals (Nyguist-Shannon-Abtasttheorem). Die Bandbreite beschreibt dabei den Frequenzbereich eines Signals, das den Analogeingang mit einem Minimum an Amplitudenabschwächung durchlaufen kann, das heißt von einer Sondenspitze oder Testkopf der Prüfvorrichtung bis zum Eingang des A/D-Wandlers. Die Bandbreite ist definiert als die Frequenz, bei welcher ein sinusförmiges Eingangssignal auf 70,7 % seiner Originalgröße abgeschwächt wird, was auch als -3 dB Grenze bezeichnet wird. Die Bandbreite kann auch definiert werden durch die Anstiegszeit *tᵣᵢₛₑ* einer Signalamplitude von 10% des Signals auf 90% und ist bestimmt durch *tᵣᵢₛₑ* = *k* / *f_{bw}.* Dabei wird der Faktor k typischerweise mit einem Wert zwischen 0,3 bis 0,45 angegeben, wobei der Faktor k für eine Bandbreite im GHz Bereich in Richtung des Wertes 0,3 gewählt wird. Standard Oszilloskope haben eine Bandbreite von 100 MHz bis 500 MHz. Um ein Signal mit einer Anstiegszeit im ps-Bereich aufzulösen, wird eine Bandbreite von größer 100 GHz benötigt.

Der vorliegenden Erfindung liegt die Aufgabe zugrunde, ein verbessertes, insbesondere präziseres und kostengünstigeres Verfahren und eine derartige Vorrichtung zur Messung einer Folge von wiederkehrenden elektronischen Signalen bereitzustellen. Insbesondere sollen dabei auch Signale mit hoher Frequenz und/oder mit kleinen Anstiegszeiten gemessen werden können.

Die Aufgabe wird erfindungsgemäß durch ein Verfahren zur Messung einer Folge von wiederkehrenden elektronischen Signalen nach den Merkmalen des Anspruchs 1 gelöst.

Erfindungsgemäß wird ein Verfahren zur Messung einer Folge von identischen oder sich ähnelnden elektronischen Signalen vorgeschlagen.

Verfahren zur Messung einer Folge von wiederkehrenden elektronischen Signalen, wobei die zu messende Folge aus n wiederkehrenden elektronischen Signalen besteht mit i = 1 bis n,
wobei ein Zeit-zu-Digital-Wandler und ein Speicher, und vorzugsweise ein Mikroprozessor bereitgestellt wird,
wobei zur Messung der Folge für ein i-tes Signal der Folge eine Spannung Uᵢ vorgegeben wird und anhand der vorgegebenen Spannung Uᵢ eine Zeit tᵢ gemessen wird, bei der das i-te Signal die vorgegebene Spannung Ui aufweist, mit den Schritten, vorzugsweise in dieser Reihenfolge:
   i) Einlesen eines i-ten Signals der Folge in einen ersten Kanal des Zeit-zu-Digital-Wandlers;
   ii) Vorgabe einer i-ten Spannung Ui und Vorgabe einer Startzeit t_{start_i} zum Starten einer Messung des i-ten Signals;
   iii) Messung der Zeit tᵢ bei der das i-te Signal die vorgegebene Spannung Uᵢ aufweist;
   iv) Speichern der vorgegebenen Spannung Ui und der gemessenen Zeit tᵢ, und/oder der Startzeit t_{start_i} und der gemessenen Zeit tᵢ, und/oder der Zeitdifferenz der Startzeit t_{start_i} und der gemessenen Zeit tᵢ;
   v) Wiederholung der Schritte i) und iv) mit einem i+1-ten Signal und einer Spannung Uᵢ₊₁, vorzugsweise bis i + 1 = n gilt oder bis die vorgegebene Spannung Ui größer ist als die maximale Spannung Uₘₐₓ des Signals;
   vi) Rekonstruieren des wiederkehrenden elektronischen Signals aus den gespeicherten Messwerten der Spannung Ui, der Startzeit t_{start_i} und der Zeit tᵢ;

Weiter wird die Aufgabe durch eine Vorrichtung zur Messung einer Folge von wiederkehrenden elektronischen Signalen nach den Merkmalen des Anspruchs 14 gelöst.

Erfindungsgemäß wird eine Vorrichtung zur Messung einer Folge von wiederkehrenden elektronischen Signalen vorgeschlagen, wobei die Vorrichtung einen Zeit-zu-Digital-Wandler (TDC), einen mit diesem verbundenen Mikroprozessor, einen von dem Mikroprozessor und/oder dem Zeit-zu-Digital-Wandler (TDC) beschreibbaren Speicher, einen Komparator im Zeit-zu-Digital-Wandler (TDC) angeordnet oder mit diesem verbunden und eine Ausgabeeinheit aufweist,
wobei der Komparator misst ob die Signalfolge aus wiederkehrenden elektronischen Signalen die vorgegebene Spannung Uᵢ aufweist und der Zeit-zu-Digital-Wandler eine Zeit tᵢ ermittelt, zu der die Signalfolge die vorgegebene Spannung Ui aufweist, und
wobei im Speicher die vorgegebene Spannung Ui und die ermittelte Zeit tᵢ und/oder eine Startzeit t_{start_i} gespeichert wird, und
wobei der Mikroprozessor die Folge von wiederkehrenden elektronischen Signalen anhand der Werte im Speicher rekonstruiert und an die Ausgabeeinheit sendet und/oder dort visuell anzeigt.

Durch das erfindungsgemäße Verfahren und die erfindungsgemäße Vorrichtung ist die zeitliche Auflösung der Messung nicht mehr durch die vorgegeben zeitlich diskreten Intervalle des Analog-Digital-Wandlers begrenzt, d.h. nicht mehr begrenzt auf die zeitliche Abtastrate. Im erfindungsgemäßen Verfahren und der erfindungsgemäßen Vorrichtung wird die Spannung Ui vorgegeben, bei der eine Messung durchgeführt werden soll und nicht, wie bei bekannten Oszilloskopen, die Zeit, bei der eine Messung durchgeführt werden soll. Von Vorteil ist dabei, dass die Ermittlung ob eine Spannung Ui vorliegt in der Regel schneller und mit höherer Genauigkeit möglich ist, als bei einer zeitdiskreten Abtastung.

Durch das erfindungsgemäße Verfahren und die erfindungsgemäße Vorrichtung können für eine verbesserte Zeitauflösung eines wiederkehrenden elektronischen Signals kostengünstigere Bauteile verwendet werden. Gleichzeitig kann durch die Vorgabe der Spannung Ui die zeitliche Auflösung der Messung um ein Vielfaches verbessert werden, was eine Rekonstruktion des Signals mit verbessertem Rauschabstand (S/N-Ratio) ermöglicht.

Unter wiederkehrenden elektronischen Signalen werden Signale verstanden, welche zumindest im Messintervall nicht oder nicht wesentlich in der zeitlichen Ausbildung und im Spannungsverlauf voneinander abweichen. Vorzugsweise bedeutet dies, dass die Abweichung der Signale kleiner ist als die Zeitauflösung oder Spannungsauflösung des Verfahrens oder der Vorrichtung, oder dass durch eine Abweichung der zeitlichen Ausbildung und des Spannungsverlaufs von einzelnen Signalen die Messung mit einer Genauigkeit mit der Zeitauflösung oder der Spannungsauflösung des Verfahrens oder der Vorrichtung erfolgen kann. Die Genauigkeit der Zeitauflösung und Spannungsauflösung hängt dabei von den verwendeten elektronischen Komponenten ab. Durch Abweichungen wird ein gemittelter Wert durch die Messung der abweichenden Signale erhalten.

Es kann vorgesehen sein, dass die Folge von elektronischen Signalen als periodische Signalfolge, vorzugsweise als zeitlich nacheinander auftretende elektronische Signale oder Pulse ausgebildet ist, wobei vorzugsweise der zeitliche Abstand der Signale oder Pulse zueinander gleich oder unterschiedlich sein kann. Es kann vorgesehen sein, dass das elektronische Signal einen zeitabhängigen Spannungsverlauf U(t) aufweist.

Es kann vorgesehen sein, dass die wiederkehrenden elektronischen Signale sich mit einer Frequenz wiederholen, die kleiner oder gleich der oberen Frequenz des Zeit-zu-Digital-Wandlers ist. Beispielsweise kann die Grenzfrequenz des Zeit-zu-Digital-Wandlers bei 20 MHz oder 50 MHz liegen und die wiederkehrenden elektronischen Signale können sich mit einer Frequenz von maximal 20 MHz, vorzugsweise 50 MHz wiederholen. Vorzugsweise mit einer Frequenz wiederholen, deren Periodendauer größer ist als die Totzeit des Zeit-zu-Digital-Wandlers. Totzeit ist die Zeitspanne, innerhalb der durch die elektronischen Komponenten, vorzugsweise den Komparator, keine weitere Messung durchgeführt werden kann.

Es ist auch möglich, dass die wiederkehrenden elektronischen Signale eine Frequenz von größer 50 MHz aufweisen, vorzugsweise größer 500 MHz, vorzugsweise bis zu 1 GHz, wobei bei derartigen Frequenzen ein Frequenzteiler (Divider) vor dem Zeit-zu-Digital-Wandler angeordnet ist. Vorzugsweise wird das Teilungsverhältnis des Frequenzteilers (Divider) derart gewählt, dass dieser die Frequenz der wiederkehrenden elektronischen Signale auf die Eingangsfrequenz des Zeit-zu-Digital-Wandlers reduziert, vorzugsweise auf maximal 20 MHz, vorzugsweise 50 MHz reduziert.

Unter Einlesen eines i-ten Signals der Folge in Schritt i) wird verstanden, dass aus der zu messenden Folge mit n wiederkehrenden elektronischen Signalen das i-te Signal der Folge ausgelesen wird, vorzugsweise an den ersten Kanal des Zeit-zu-Digital-Wandlers übergeben wird.

Es kann vorgesehen sein, dass ein, vorzugsweise einstellbarer oder programmierbarer, Frequenzteiler (Divider) vor dem Zeit-zu-Digital-Wandler angeordnet ist. Insbesondere weist der Frequenzteiler einen Teilungsfaktor k auf und der Zeit-zu-Digital-Wandler misst nur jedes k-te Signal. Vorzugsweise wird der Teilungsfaktor k des Frequenzteilers derart vorgegeben oder eingestellt, dass jedes k-te Signal nicht mehr in der Totzeit des Zeit-zu-Digital-Wandlers liegt. Dadurch ist es möglich wiederkehrende elektronischen Signale zu messen, welche sich mit einer Frequenz wiederholen, deren Periodendauer kleiner oder deutlich kleiner ist als die Totzeit des Zeit-zu-Digital-Wandlers. Dadurch können relativ kostengünstige Zeit-zu-Digital-Wandler auch bei hohen Frequenzen eingesetzt werden und es ist möglich, auch hochfrequente Signale aufzulösen.

Es kann vorgesehen sein, dass die Messung in Schritt iii) für die steigende und/oder fallende Flanke des i-te Signals durchgeführt wird.

Es kann vorgesehen sein, dass die Schritte i) bis iv) mit gleicher vorgegebener Spannung Ui bei einem i-ten Signal für eine steigende Flanke und bei einem i+1-ten Signal für eine fallende Flanke wiederholt werden. Vorzugsweise gilt dann für Schritt v) eine Wiederholung der Schritte i) und iv) mit einem i+2-ten Signal und einer Spannung Uᵢ₊₁, vorzugsweise bis 2 * i = n vorherrscht oder bis die vorgegebene Spannung Ui größer ist als die maximale Spannung Uₘₐₓ des Signals;

Es kann vorgesehen sein, dass die vorgegebene Spannung Ui für jede weitere i-te Messung schrittweiße erhöht wird, wobei die Schritte konstant oder nicht konstant sein können. Vorzugsweise gilt Uᵢ₊₁ = Uᵢ + ΔU wobei ΔU die Spannungserhöhung darstellt. Vorzugsweise ist ΔU konstant oder variabel für unterschiedliche i.

Es kann vorgesehen sein, dass der Zeit-zu-Digital-Wandler, vorzugsweise in Schritt iii), für jedes Ui Zeiten oder ein Zeitintervall misst, wobei die Zeiten die Startzeit t_{start_i} und/oder die gemessene Zeit tᵢ sind und das Zeitintervall die Differenz der Startzeit t_{satrt_i} und der gemessenen Zeit tᵢ ist.

Es kann vorgesehen sein, dass in Schritt iii) die Messung der Zeit tᵢ im Zeit-zu-Digital-Wandler durchgeführt wird.

Es kann vorgesehen sein, dass in Schritt iii) zur Messung der Zeit tᵢ die vorgegebene Spannung Ui mit dem i-ten Signal verglichen wird, vorzugsweise im Zeit-zu-Digital-Wandler oder im Komparator verglichen wird.

Es kann vorgesehen sein, dass der Zeit-zu-Digital-Wandler die Zeit tᵢ durch eine vorgegebene Spannungsschwelle, welche der vorgegebenen Spannung Uᵢ entspricht, ermittelt, oder dass der Zeit-zu-Digital-Wandler die Zeit tᵢ durch ein Triggersignal eines Komparators ermittelt.

Es kann vorgesehen sein, dass die vorgegebene Spannung Ui durch den Zeit-zu-Digital-Wandler vorgegeben wird, oder dass die vorgegebene Spannung Ui durch eine vorzugsweise einstellbare und/oder programmierbare Referenzquelle oder durch einen Digital-zu-Analog-Wandler vorgegeben wird und an den Zeit-zu-Digital-Wandler oder an den Komparator übermittelt wird. Es kann vorgesehen sein, dass der Digital-zu-Analog-Wandler im Zeit-zu-Digital-Wandler angeordnet ist oder vor dem Zeit-zu-Digital-Wandler angeordnet ist.

Es kann vorgesehen sein, dass der Zeit-zu-Digital-Wandler einen Komparator und/oder einen Digital-zu-Analog-Wandler aufweist, oder dass vor dem Zeit-zu-Digital-Wandler ein Komparator und/oder ein Digital-zu-Analog-Wandler angeordnet ist. Der Komparator dient dabei zum Vergleich der vorgegebenen Spannung mit dem Signal; der Digital-zu-Analog-Wandler dient zur Vorgabe der vorgegebenen Spannung Ui an den Digital-zu-Analog-Wandler oder den Komparator.

Es kann vorgesehen sein, dass jedes i-te Signal der Folge in den ersten Kanal des Zeit-zu-Digital-Wandlers eingespeist wird und die Schritte i) bis vi) durchgeführt werden, oder
dass x-Zeit-zu-Digital-Wandler oder ein Zeit-zu-Digital-Wandler mit x Kanälen im Verfahren genutzt werden und/oder in der Vorrichtung angeordnet sind, wobei jeder der x Zeit-zu-Digital-Wandler oder Kanäle die Schritte i) bis vi) durchführt, wobei vorzugsweise vorgesehen ist, dass x ≤ i gilt, wobei für x < i die x Zeit-zu-Digital-Wandler jeweils die Schritte i) bis vi) i / x mal durchführen.

Es kann vorgesehen sein, dass der Komparator und/oder der Zeit-zu-Digital-Wandler ein Auflösungsvermögen von mindestens 1 mV, vorzugsweise 1 µV, höchst vorzugsweise 10 nV aufweist.

Es kann vorgesehen sein, dass das wiederkehrende elektronische Signal direkt in den Zeit-zu-Digital-Wandler eingelesen wird, oder
dass vor dem Zeit-zu-Digital-Wandler ein Filter und/oder Verstärker und/oder Signalteiler und/oder Leistungsteiler und/oder ein Dämpfungsglied angeordnet ist.

Es kann vorgesehen sein, dass der Signalteiler und/oder Leistungsteiler das elektronische Signal in zwei elektronische Signale bzw. zwei Signalpfade aufteilt, vorzugweise in ein erstes aufgeteiltes elektronisches Signal und ein zweites aufgeteiltes elektronisches Signal.

Es kann vorgesehen sein, dass der Signalteiler und/oder Leistungsteiler das elektronische Signal derart aufteilt, dass das erste aufgeteilte elektronische Signal und das zweite aufgeteilte elektronische Signal ein gleiches Spannungsverhältnis aufweisen oder dass die aufgeteilten Signale ein unterschiedliches Spannungsverhältnis aufweisen. Beispielsweise ein Spannungsverhältnis zwischen 1 : 1 und 1 : 2 aufweisen, vorzugsweise zwischen 1 : 2 und 1 : 3 aufweisen, höchst vorzugsweise zwischen 1 : 3 und 1 : 5 aufweisen.

Es kann vorgesehen sein, dass das erste aufgeteilte elektronische Signal in einen ersten Kanal des Zeit-zu-Digital-Wandler eingespeist wird und das zweite aufgeteilte elektronische Signal in einen zweiten Kanal des Zeit-zu-Digital-Wandler eingespeist wird, oder das zweite aufgeteilte elektronische Signal in einen zweiten Zeit-zu-Digital-Wandler eingespeist wird. Vorzugsweise wird sowohl das erste als auch das zweite aufgeteilte elektronische Signal zur Messung der Schritte i) bis vi) verwendet.

Es kann vorgesehen sein, dass in Schritt ii) die Vorgabe einer Startzeit tₛₜₐᵣₜ durch ein Startsignal erfolgt.

Es kann vorgesehen sein, dass das Startsignal durch den Zeit-zu-Digital-Wandler oder eine externe Uhr vorgegeben wird. Dabei kann vorgesehen sein, dass die externe Uhr aus einem weiteren Signal abgeleitet ist, oder aus dem Mikroprozessor erzeugt wird oder durch einen externen Signalgenerator erzeugt wird. Vorzugsweise wird das Startsignal der externen Uhr an den Zeit-zu-Digital-Wandler übermittelt, um die Startzeit tₛₜₐᵣₜ vorzugeben.

Es kann vorgesehen sein, dass das Startsignal
- ein weiteres Signal eines Startsignal-Kanals ist, vorzugsweise erzeugt durch eine externe Uhr oder durch den Signalteiler und/oder Leistungsteiler, oder
- ein Startsignal ist, welches intern in der Vorrichtung erzeugt und/oder definiert wird, vorzugsweise durch den Mikroprozessor oder ein Taktgeber oder eine andere elektronische Komponente.

Es kann vorgesehen sein, dass die Startzeit tₛₜₐᵣₜ für alle Signale einer Folge zu einem festen Zeitpunkt vor oder während jedem Signal erfolgt, oder dass der Zeitpunkt der Startzeit tₛₜₐᵣₜ vor oder während des Signals für verschiedene Signale variiert. Der Vorteil eines festen Zeitpunkts liegt in der einfachen Rekonstruierung des wiederkehrenden elektronischen Signals. Der Vorteil der Variation liegt darin, dass auch komplexere Signalfolgen, insbesondere variable Signale mit mehreren steigenden und/oder fallenden Flanken, gemessen und rekonstruiert werden können.

Es kann vorgesehen sein, dass das Startsignal oder das zweite aufgeteilte elektronische Signal in einen zweiten Kanal des Zeit-zu-Digital-Wandlers eingespeist wird, vorzugsweise dass das zweite aufgeteilte elektronische Signal als Startsignal an den Zeit-zu-Digital-Wandler übermittelt wird, oder im Zeit-zu-Digital-Wandler benutzt wird. Es kann vorgesehen sein, dass der Zeit-zu-Digital-Wandler für den zweiten Kanal einen zweiten Komparator und/oder einen zweiten Digital-zu-Analog-Wandler aufweist, oder dass für den zweiten Kanal ein externer zweiter Komparator und/oder ein externer zweiter Digital-zu-Analog-Wandler angeordnet ist.

Es kann vorgesehen sein, dass das zweite aufgeteilte elektronische Signal das Startsignal darstellt, vorzugsweise wird die Startzeit tₛₜₐᵣₜ durch das zweite aufgeteilte elektronische Signal vorgegeben. Vorzugsweise ist die Startsignalspannung Start, durch welche die Startzeit tₛₜₐᵣₜ aus dem zweiten aufgeteilten elektronischen Signal ermittelt wird, frei wählbar, höchst vorzugsweise entspricht die Startsignalspannung Uₛₜₐᵣₜ der halben Spannung des zweiten aufgeteilten elektronischen Signals. Vorzugsweise ist die Startsignalspannung Uₛₜₐᵣₜ durch eine einstellbare und/oder programmierbare Referenzquelle vorgegeben oder durch einen Digital-zu-Analog-Wandler vorgegeben.

Es kann vorgesehen sein, dass das erste aufgeteilte elektronische Signal und/oder das zweite aufgeteilte elektronische Signal vor oder in dem Zeit-zu-Digital-Wandler um eine vorgegebene oder einstellbare Zeit verzögert wird. Vorzugsweise erfolgt die Verzögerung fest vorgegeben, vorzugsweise durch eine Kabelführung mit einer bestimmten Kabellänge, oder elektronisch, vorzugsweise durch eine Programmierung oder ein Verzögerungsglied.

Es kann vorgesehen sein, dass das erste und das zweite aufgeteilte elektronische Signal in den ersten Kanal des Zeit-zu-Digital-Wandler eingespeist wird, indem das zweite aufgeteilte elektronische Signal verzögert wird. Vorzugsweise werden die Startzeit tₛₜₐᵣₜ und die gemessene Zeit tᵢ des Signals oder die Zeitdifferenz tᵢ - tₛₜₐᵣₜ gespeichert.

Es kann vorgesehen sein, dass die Schritte i) bis iv) bei gleicher Spannung Ui für mehrere Signale j wiederholt werden, vorzugsweise vor dem Schritt v) wiederholt werden, vorzugsweise j mal wiederholt werden, um die Zeiten tᵢⱼ zu messen. Dabei gilt j = 1 bis m mit ganzzahligen j. Damit ist es möglich eine bessere Zeitauflösung zu erzielen, welche unterhalb des Jitters (zeitliche Fluktuation) des Zeit-zu-Digital-Wandlers liegt.

Es kann vorgesehen sein, dass aus den mehreren Zeiten tᵢⱼ der gleichen Spannung Ui für mehrere Signale j ein gemittelter Wert U_{i_mittel} berechnet wird. Vorzugsweise wird die Berechnung durch eine Mittelwertbildung oder einer Extraktion des Mittelwerts aus einer Abschätzung der Verteilung der Messwerte ermittelt. Damit ist es möglich, die Auflösung des Verfahrens und der Vorrichtung weiter zu verbessern.

Es kann vorgesehen sein, dass zur Rekonstruierung des wiederkehrenden elektronischen Signals Werte zwischen den gespeicherten Messwerten der Zeit tᵢ durch einen Interpolationsalgorithmus abgeschätzt werden. Insbesondere bei schwachen Signalen ermöglicht dies eine bessere Messung bzw. Rekonstruierung der Signale.

Es kann vorgesehen sein, dass die Ausgabeeinheit als ein Bildschirm ausgebildet ist. Es kann vorgesehen sein, dass das rekonstruierte wiederkehrende elektronische Signal in der Ausgabeeinheit visuell angezeigt wird.

Es kann vorgesehen sein, dass das wiederkehrende elektronische Signal direkt elektronisch vorliegt, oder durch einen Wandler in ein elektronisches Signal umgewandelt werden. Vorzugsweise kann als Wandler ein Detektor, oder eine Antenne, oder ein Verstärker oder eine Vorrichtung, welche eine Messgröße in ein elektronisches Signal umwandelt, verwendet werden. Vorzugsweise kann der Detektor als eine schnelle Photodiode ausgebildet sein, um optische Signale zu messen. Alternativ kann der Detektor als eine Antenne ausgebildet sein, um ein magnetisches oder elektromagnetisches Signal zu messen.

Es kann vorgesehen sein, dass der Zeit-zu-Digital-Wandler als ein separates Bauteil und/oder als ein FPGA (Field Programmable Gate Array) basierender Zeit-zu-Digital-Wandler ausgebildet ist. Dabei beschreibt FPGA (Field Programmable Gate Array oder programmierbare (Logik-)Gatter-Anordnung) einen integrierten Schaltkreis, in dem eine logische Schaltung geladen werden kann. Dabei können nicht nur die zeitlichen Abläufe programmiert werden, sondern auch gewünschte Schaltungsstrukturen definiert werden.

Es kann vorgesehen sein, dass das erste aufgeteilte elektronische Signal und/oder das zweite aufgeteilte elektronische Signal im FPGA basierenden Zeit-zu-Digital-Wandler verzögert wird. Damit ist es möglich, eine Verzögerung zwischen dem ersten und zweiten aufgeteilten elektronischen Signal beliebig zu wählen und auch zu variieren.

Eine Anwendung des erfindungsgemäßen Verfahrens kann beispielsweise bei dem Betrieb von Oszilloskopen Verwendung finden oder in einem Oszilloskop als ein Messverfahren integriert werden. Die erfindungsgemäße Vorrichtung kann als ein Oszilloskop ausgebildet sein, oder als ein Einschub oder als ein Zusatzbaustein für ein Oszilloskop ausgebildet sein. Die Anwendung des erfindungsgemäßen Verfahrens kann auch vorsehen, dass das erfindungsgemäße Verfahren in einen, vorzugsweise bereits verbauten oder vorhandenen, TDC als zusätzliches Messverfahren integriert wird. Beispielsweise als ein Messmodul und/oder als ein Messprogramm.

Weitere Ausführungen der Erfindung sind in den Figuren dargestellt und nachfolgend beschrieben. In den Figuren ist beispielhaft eine mögliche Ausgestaltung der Erfindung gezeigt. Diese Ausgestaltung dient der Erläuterung einer möglichen Umsetzung der Erfindung und soll nicht eingrenzend verstanden werden. Dabei zeigen:
- Fig. 1:: Eine schematische Darstellung eines ersten Ausführungsbeispiels der erfindungsgemäßen Vorrichtung;
- Fig. 2:: Eine schematische Darstellung eines zweiten Ausführungsbeispiels der erfindungsgemäßen Vorrichtung mit einen Frequenzteiler;
- Fig. 3:: Eine schematische Darstellung eines dritten Ausführungsbeispiels der erfindungsgemäßen Vorrichtung mit einen Signalteiler;
- Fig. 4:: Eine schematische Darstellung eines wiederkehrenden elektronischen Signals mit vorgegebenen Spannungen;
- Fig. 5:: Eine schematische Darstellung eines ersten und zweiten elektronischen Signals mit vorgegebenen Spannungen und Startzeitbestimmung;
- Fig. 6:: Diagramm der Verbesserung der Zeitauflösung Δt des erfindungsgemäßen Verfahrens in Abhängigkeit der wiederholten Messung der vorgegebenen Spannung Uᵢ.

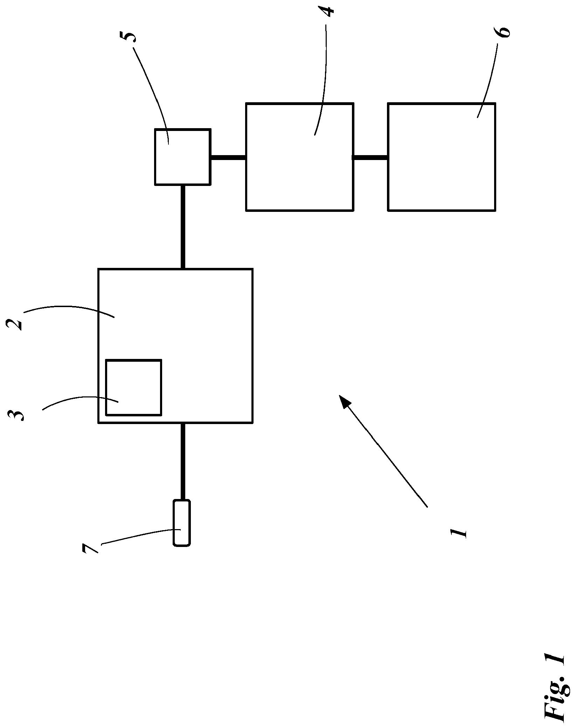

Fig. 1 zeigt eine schematische Darstellung eines ersten Ausführungsbeispiels der erfindungsgemäßen Vorrichtung 1 zur Messung einer Folge von wiederkehrenden elektronischen Signalen.

Durch einen Tastkopf 7 wird eine Folge von wiederkehrenden elektronischen Signalen 10 über eine Leitung in einen Zeit-zu-Digital-Wandler 2 eingelesen. Die Folge besteht aus n wiederkehrenden elektronischen Signalen 10, wobei n eine ganzzahlige Zahl ist. Die einzelnen Signale 10 der Folge erreichen den Zeit-zu-Digital-Wandler 2 nacheinander, wobei das i-te Signal 10 ein einzelnes Signal 10 der Folge beschreibt mit i = 1, 2, ... bis n. Unter Einlesen eines i-ten Signals 10 der Folge wird verstanden, dass aus der zu messenden Folge mit n wiederkehrenden elektronischen Signalen 10 das i-te Signal 10 der Folge ausgelesen wird, d.h. an den ersten Kanal des Zeit-zu-Digital-Wandlers 2 übergeben wird.

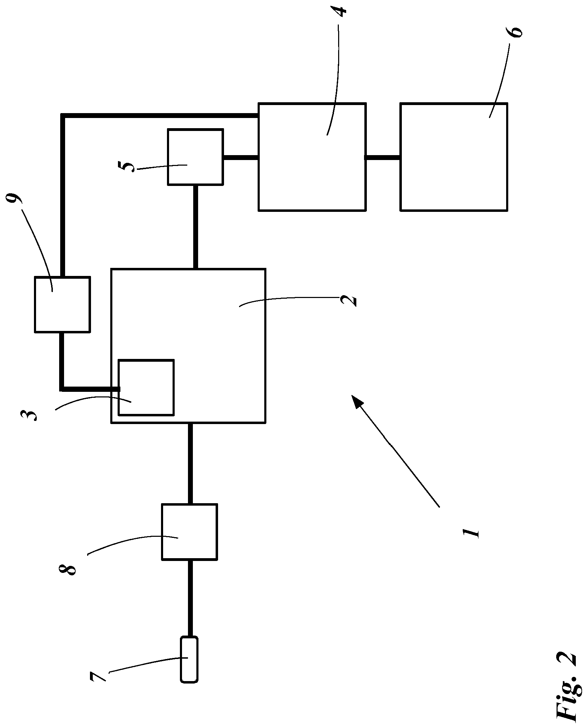

Der Zeit-zu-Digital-Wandler 2, welcher im Ausführungsbeispiel der Fig. 1 einen Komparator 3 enthält, misst die Zeit tᵢ, bei der das i-te Signal 10 eine vorgegebene Spannung Ui aufweist. Im Ausführungsbeispiel der Fig. 1 wird durch den Zeit-zu-Digital-Wandler 2 ein Startsignal vorgegeben, welches das erfindungsgemäße Verfahren startet oder eine Startzeit tₛₜₐᵣₜ für jedes i-te Signal 10 definiert, um zur anschließenden Auswertung der gemessenen Daten der mehreren Signale 10 jeweils einen Referenzstartzeitpunkt zu definieren. Die vorgegebene Spannung Uᵢ wird im Ausführungsbeispiel der Fig. 1 durch den Zeit-zu-Digital-Wandler 2 vorgegeben. Es sind auch Ausführungen möglich, bei denen die vorgegebene Spannung Ui durch eine Referenzquelle 9 vorgegeben wird und an den Zeit-zu-Digital-Wandler 2 oder an den Komparator 3 übermittelt wird (siehe Fig. 2). Für die Messung des Zeitpunkts tᵢ an dem das Signal 10 die vorgegebene Spannung Ui aufweist vergleicht der Komparator 3 die vorgegebenen Spannung Ui mit dem i-ten Signal 10. Der Komparator 3 erzeugt einen elektronischen Puls, wenn das wiederkehrende Signal 10 die vorgegebene Spannung Ui aufweist und übermittelt diesen an den Zeit-zu-Digital-Wandler 2, der die Zeit tᵢ bestimmt und an einen Speicher 5 weiterleitet.

Im Speicher 5 werden die Zeiten tᵢ sowie die entsprechenden vorgegebenen Spannungen Ui gespeichert und anschließend vom Mikroprozessor 4 ausgewertet. Zusätzlich kann die Startzeit tₛₜₐᵣₜ für jedes wiederkehrende Signal 10 gespeichert werden und/oder das Zeitintervall zwischen tᵢ und tₛₜₐᵣₜ. Die ausgewerteten Daten werden auf einer Ausgabeeinheit 6, welche als ein Monitor ausgebildet sein kann, dargestellt.

In der Fig. 2 wird ein zweites Ausführungsbeispiel der erfindungsgemäßen Vorrichtung 1 dargestellt. Im Unterschied zur Fig. 1 wird die vorgegebene Spannung Ui von einer Referenzquelle 9 an den Komparator 2 übermittelt. Die Referenzquelle 9 ist in diesem Ausführungsbeispiel außerhalb des Zeit-zu-Digital-Wandlers 2 als separate Komponente ausgebildet. Die Referenzquelle 9 wird im Ausführungsbeispiel der Fig. 2 vom Mikroprozessor gesteuert, um die Spannung Ui für jedes i-te Signal vorzugeben.

Weiter ist in Fig. 2, im Gegensatz zu Fig. 1, ein Frequenzteiler 8 vor dem Zeit-zu-Digital-Wandler 2 angeordnet. Durch den Frequenzteiler 8 ist es möglich, eine Folge von wiederkehrenden Signalen 10 zu messen, welche eine Frequenz zwischen den Signalen 10 aufweisen, die größer als die Totzeit des Zeit-zu-Digital-Wandler 2 ist. Der Frequenzteiler 8 faktorisiert die wiederkehrenden Signale 10 und leitet nur noch jedes k-te wiederkehrende Signal 10 an den Zeit-zu-Digital-Wandler 2 weiter, welches dann im Zeit-zu-Digital-Wandler 2 zur Messung benutzt wird. Zu beachten ist, dass der Frequenzteiler 8 und auch die Referenzquelle 9 alleine im Ausführungsbeispiel der Fig. 2 ausgebildet sein können.

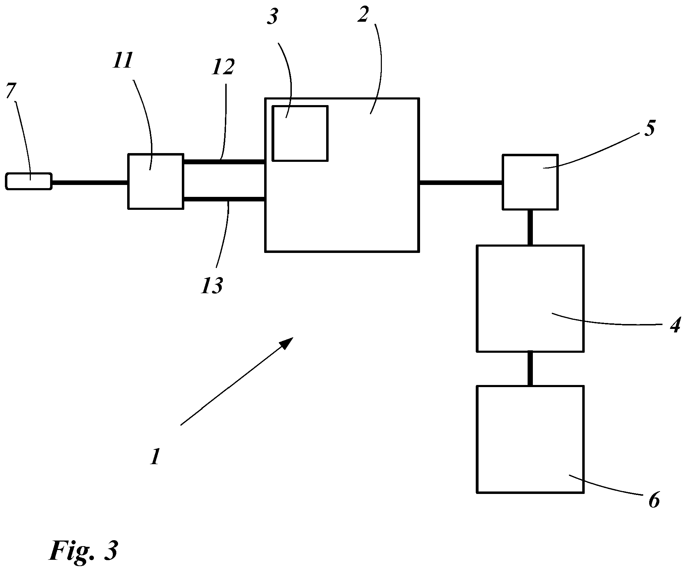

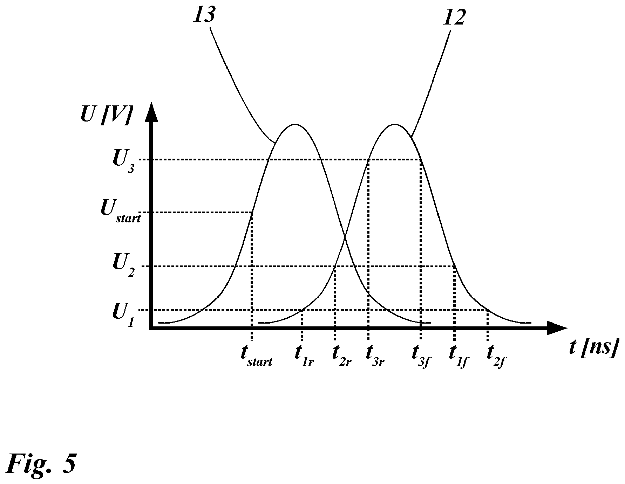

In der Fig. 3 wird ein drittes Ausführungsbeispiel der erfindungsgemäßen Vorrichtung 1 dargestellt. Im Unterschied zur Fig. 1 ist ein Signalteiler 11 vor dem Zeit-zu-Digital-Wandler 2 angeordnet, welcher jedes Signal 10 der Folge in zwei Signale aufteilt, ein erstes i-tes elektronisches Signal 12 und ein zweites i-tes elektronisches Signal. Im Ausführungsbeispiel der Fig. 3 wird das erstes i-te elektronische Signal 12 in einen ersten Kanal des Zeit-zu-Digital-Wandler 2 eingelesen und das zweite i-te elektronische Signal 13 in einen zweiten Kanal des Zeit-zu-Digital-Wandler 2. Das zweite i-te elektronische Signal 13 dient im Ausführungsbeispiel der Fig. 3 zur Bestimmung der Startzeit tₛₜₐᵣₜ. Dazu ist im Zeit-zu-Digital-Wandler 2 ein zweiter Komparator 3 (nicht dargestellt in Fig. 3) ausgebildet, welcher eine Startspannung Uₛₜₐᵣₜ vom Zeit-zu-Digital-Wandler 2 erhält und daraus die Startzeit tₛₜₐᵣₜ ermittelt, zu der die Messung gestartet wird oder eine Startzeit tₛₜₐᵣₜ für jedes i-te Signal 10 definiert, um zur anschließenden Auswertung der gemessenen Daten der mehreren Signale 10 jeweils einen Referenzstartzeitpunkt zu definieren. Im Ausführungsbeispiel der Fig. 3 ist das erste i-te elektronische Signal 12 zum zweiten i-ten elektronischen Signal 13 zeitlich verzögert (siehe Fig. 5). Die Verzögerung erfolgt, damit der Zeit-zu-Digital-Wandler 2 in diesem Ausführungsbeispiel zuerst die Startzeit tₛₜₐᵣₜ ermittelt und danach die Messung der Zeit tᵢ erfolgt. Die Verzögerung kann elektronisch im Zeit-zu-Digital-Wandler 2 oder durch eine entsprechende Kabelführung vor oder im Zeit-zu-Digital-Wandler 2 erfolgen.

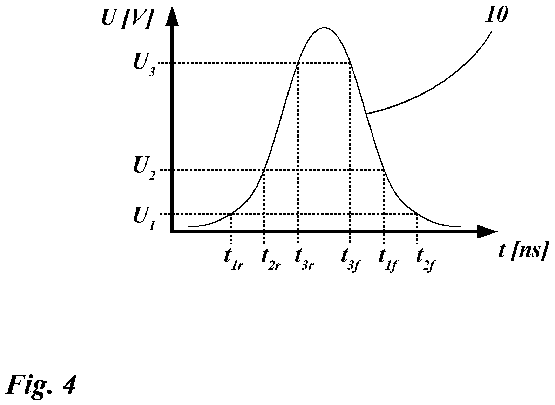

In der Fig. 4 wird beispielhaft ein wiederkehrendes Signal 10 dargestellt, sowie die vorgegebenen Spannungen U₁, U₂ und U₃ und die durch die Messungen erhaltenen Zeiten tᵢ für die steigende und fallende Flanke des Signals 10. Zu beachten ist dabei, dass die mehreren Messungen der Zeiten tᵢ nicht an einem Signal 10 durchgeführt werden, sondern für jede Messung ein eigenes i-tes Signal 10 verwendet wird.

In der Fig. 5 werden das erste elektronische Signal 12 und das zweite elektronische Signal 13 zur Bestimmung der Startzeit tₛₜₐᵣₜ und zur Messung der Zeiten tᵢ der steigenden und fallenden Flanke des Signals 10 für die Spannungen U₁, U₂ und U₃ dargestellt. Das erste elektronische Signal 12 und das zweite elektronische Signal 13 kann durch eine Vorrichtung wie beispielsweise in Fig. 3 beschrieben erhalten werden. Das erste elektronische Signal 12 ist dabei zeitlich verzögert zum zweiten elektronischen Signal 13 in den Zeit-zu-Digital-Wandler 2 eingelesen worden oder wird im Zeit-zu-Digital-Wandler 2 zeitlich verzögert. Damit wird durch das zweite elektronische Signal 13 und der Vorgabe der Startspannung Uₛₜₐᵣₜ eine Startzeit tₛₜₐᵣₜ durch das eigene wiederkehrende Signal 10 ermittelt.

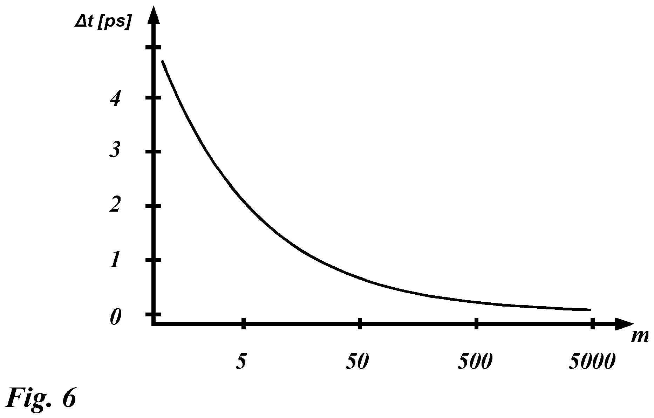

Fig. 6 zeigt ein Diagramm der Verbesserung der Zeitauflösung Δt des erfindungsgemäßen Verfahrens in Abhängigkeit der wiederholten Messung der vorgegebenen Spannung Ui, wobei m die Anzahl der Messungen sind auf der logarithmischen x-Achse in Fig. 6. Beispielhaft wird in Fig. 6 der Jitters (zeitliche Fluktuationen) des Zeit-zu-Digital-Wandlers 2 mit 2.4 ps angenommen. Wie in Fig. 6 dargestellt, kann die Zeitauflösung des erfindungsgemäßen Verfahrens und der Vorrichtung auf unter 1 ps verbessert werden bei weniger als 50 Messungen pro vorgegebener Spannung Uᵢ.

### Bezugszeichenliste

- 1: Vorrichtung zur Messung
- 2: Zeit-zu-Digital-Wandler
- 3: Komparator
- 4: Mikroprozessor
- 5: Speicher
- 6: Ausgabeeinheit
- 7: Tastkopf
- 8: Frequenzteiler / Divider
- 9: Referenzquelle
- 10: Signal
- 11: Signalteiler
- 12: erstes elektronisches Signal
- 13: zweites elektronisches Signal

## Patentansprüche

1. Verfahren zur Messung einer Folge von wiederkehrenden elektronischen Signalen (10), wobei die zu messende Folge aus n wiederkehrenden elektronischen Signalen besteht mit i = 1 bis n,
wobei ein Zeit-zu-Digital-Wandler (2) und ein Speicher (5), und vorzugsweise ein Mikroprozessor (4) bereitgestellt wird,
**dadurch gekennzeichnet,**
wobei zur Messung der Folge für ein i-tes Signal der Folge eine Spannung Ui vorgegeben wird und anhand der vorgegebenen Spannung Ui eine Zeit tᵢ gemessen wird, bei der das i-te Signal (10) die vorgegebene Spannung Uᵢ aufweist, mit den Schritten, vorzugsweise in dieser Reihenfolge:
i) Einlesen eines i-ten Signals der Folge in einen ersten Kanal des Zeit-zu-Digital-Wandlers (2);
ii) Vorgabe einer i-ten Spannung Ui und Vorgabe einer Startzeit t_{start_i} zum Starten einer Messung des i-ten Signals;
iii) Messung der Zeit tᵢ bei der das i-te Signal die vorgegebene Spannung Uᵢ aufweist;
iv) Speichern der vorgegebenen Spannung Ui und der gemessenen Zeit tᵢ, und/oder der Startzeit t_{start_i} und der gemessenen Zeit tᵢ, und/oder der Zeitdifferenz der Startzeit t_{start_i} und der gemessenen Zeit tᵢ;
v) Wiederholung der Schritte i) und iv) mit einem i+1-ten Signal (10) und einer Spannung Uᵢ₊₁, vorzugsweise bis i + 1 = n gilt oder bis die vorgegebene Spannung Ui größer ist als die maximale Spannung Uₘₐₓ des Signals (10);
vi) Rekonstruieren des wiederkehrenden elektronischen Signals (10) aus den gespeicherten Messwerten der Spannung Ui, der Startzeit t_{start_i} und der Zeit t;;

2. Verfahren nach Anspruch 1,
**dadurch gekennzeichnet,**
**dass** die Schritte i) bis iv) mit gleicher vorgegebener Spannung Ui bei einem i-ten Signal (10) für eine steigende Flanke und bei einem i+1-ten Signal (10) für eine fallende Flanke wiederholt werden.

3. Verfahren nach Anspruch 1 oder 2,
**dadurch gekennzeichnet,**
**dass** die vorgegebene Spannung Ui für jede weitere i-te Messung schrittweiße erhöht wird, wobei die Schritte konstant oder nicht konstant sein können.

4. Verfahren nach einem der Ansprüche 1 bis 3,
**dadurch gekennzeichnet,**
**dass** der Zeit-zu-Digital-Wandler (2), vorzugsweise in Schritt iii), für jedes Uᵢ Zeiten oder ein Zeitintervall misst, wobei die Zeiten die Startzeit t_{start_i} und/oder die gemessene Zeit tᵢ sind und das Zeitintervall die Differenz der Startzeit t_{start_i} und der gemessenen Zeit tᵢ ist.

5. Verfahren nach einem der Ansprüche 1 bis 4,
**dadurch gekennzeichnet,**
**dass** in Schritt iii) zur Messung der Zeit tᵢ die vorgegebene Spannung Ui mit dem i-ten Signal (10) verglichen wird, vorzugsweise im Zeit-zu-Digital-Wandler (2) oder im Komparator (3) verglichen wird.

6. Verfahren nach einem der Ansprüche 1 bis 5,
**dadurch gekennzeichnet,**
**dass** der Zeit-zu-Digital-Wandler (2) die Zeit tᵢ durch eine vorgegebene Spannungsschwelle, welche der vorgegebenen Spannung Ui entspricht, ermittelt, oder dass der Zeit-zu-Digital-Wandler (2) die Zeit tᵢ durch ein Triggersignal eines Komparators (3) ermittelt.

7. Verfahren nach einem der Ansprüche 1 bis 6,
**dadurch gekennzeichnet,**
**dass** die vorgegebene Spannung Ui durch den Zeit-zu-Digital-Wandler (2) vorgegeben wird, oder dass die vorgegebene Spannung Ui durch eine vorzugsweise einstellbare und/oder programmierbare Referenzquelle (9) oder durch einen Digital-zu-Analog-Wandler (2) vorgegeben wird und an den Zeit-zu-Digital-Wandler (2) oder an den Komparator (3) übermittelt wird, vorzugsweise dass der Digital-zu-Analog-Wandler (2) im Zeit-zu-Digital-Wandler (2) angeordnet ist oder vor dem Zeit-zu-Digital-Wandler (2) angeordnet ist.

8. Verfahren nach einem der Ansprüche 1 bis 7,
**dadurch gekennzeichnet,**
**dass** jedes i-te Signal (10) der Folge in den ersten Kanal des Zeit-zu-Digital-Wandlers (2) eingespeist wird und die Schritte i) bis vi) durchgeführt werden, oder
**dass** x-Zeit-zu-Digital-Wandler (2) oder ein Zeit-zu-Digital-Wandler (2) mit x Kanälen im Verfahren genutzt werden und/oder in der Vorrichtung angeordnet sind, wobei jeder der x Zeit-zu-Digital-Wandler (2) oder Kanäle die Schritte i) bis vi) durchführt, wobei vorzugsweise vorgesehen ist, dass x ≤ i gilt, wobei für x < i die x Zeit-zu-Digital-Wandler (2) jeweils die Schritte i) bis vi) i / x mal durchführen.

9. Verfahren nach einem der Ansprüche 1 bis 8,
**dadurch gekennzeichnet,**
**dass** das wiederkehrende elektronische Signal (10) direkt in den Zeit-zu-Digital-Wandler (2) eingelesen wird, oder dass vor dem Zeit-zu-Digital-Wandler (2) ein Filter und/oder Verstärker und/oder Signalteiler (11) und/oder Leistungsteiler und/oder ein Dämpfungsglied angeordnet ist, und vorzugsweise dass der Signalteiler (11) und/oder Leistungsteiler das elektronische Signal (10) in zwei elektronische Signale (10) bzw. zwei Signalpfade aufteilt, vorzugweise in ein erstes aufgeteiltes elektronisches Signal (12) und ein zweites aufgeteiltes elektronisches Signal (13).

10. Verfahren nach Anspruch 9,
**dadurch gekennzeichnet,**
**dass** das erste aufgeteilte elektronische Signal (12) in einen ersten Kanal des Zeit-zu-Digital-Wandler (2) eingespeist wird und das zweite aufgeteilte elektronische Signal (13) in einen zweiten Kanal des Zeit-zu-Digital-Wandler (2) eingespeist wird, oder das zweite aufgeteilte elektronische Signal (13) in einen zweiten Zeit-zu-Digital-Wandler (2) eingespeist wird, vorzugsweise wird sowohl das erste als auch das zweite aufgeteilte elektronische Signal (13) zur Messung der Schritte i) bis vi) verwendet, oder eines der beiden Signale (12, 13) zur Messung der Startzeit tₛₜₐᵣₜ.

11. Verfahren nach einem der Ansprüche 9 oder 10,
**dadurch gekennzeichnet,**
**dass** das erste und das zweite aufgeteilte elektronische Signal (10) in den ersten Kanal des Zeit-zu-Digital-Wandler (2) eingespeist wird, indem das zweite aufgeteilte elektronische Signal (13) verzögert wird, vorzugsweise werden die Startzeit tₛₜₐᵣₜ und die gemessene Zeit tᵢ des Signals (10) oder die Zeitdifferenz tᵢ - tₛₜₐᵣₜ gespeichert.

12. Verfahren nach einem der Ansprüche 1 bis 11,
**dadurch gekennzeichnet,**
**dass** in Schritt ii) die Vorgabe einer Startzeit tₛₜₐᵣₜ durch ein Startsignal erfolgt, vorzugsweise dass das Startsignal durch den Zeit-zu-Digital-Wandler (2) oder eine externe Uhr vorgegeben wird, oder vorzugsweise dass das Startsignal ein weiteres Eingangssignal eines Startsignal-Kanals ist, vorzugsweise erzeugt durch eine externe Uhr oder durch den Signalteiler (11) und/oder Leistungsteiler, oder ein Startsignal ist, welches intern in der Vorrichtung erzeugt und/oder definiert wird, vorzugsweise durch den Mikroprozessor (4) oder ein Taktgeber oder eine andere elektronische Komponente.

13. Verfahren nach einem der Ansprüche 1 bis 12,
**dadurch gekennzeichnet,**
**dass** die Schritte i) bis iv) bei gleicher Spannung Ui für mehrere Signale (10) j wiederholt werden, vorzugsweise vor dem Schritt v) wiederholt werden, vorzugsweise j mal wiederholt werden, um die Zeiten tᵢⱼ zu messen. Dabei gilt j = 1 bis m mit ganzzahligen j.

14. Vorrichtung (1) zur Messung einer Folge von wiederkehrenden elektronischen Signalen vorgeschlagen, wobei die Vorrichtung einen Zeit-zu-Digital-Wandler (2) (TDC), einen mit diesem verbundenen Mikroprozessor (4), einen von dem Mikroprozessor (4) und/oder dem Zeit-zu-Digital-Wandler (2) (TDC) beschreibbaren Speicher (5), einen Komparator (3) im Zeit-zu-Digital-Wandler (2) (TDC) angeordnet oder mit diesem verbunden und eine Ausgabeeinheit (6) aufweist,
**dadurch gekennzeichnet,**
**dass** der Komparator (3) misst ob die Signalfolge aus wiederkehrenden elektronischen Signalen (10) die vorgegebene Spannung Ui aufweist und der Zeit-zu-Digital-Wandler (2) eine Zeit tᵢ ermittelt, zu der die Signalfolge die vorgegebene Spannung Ui aufweist, und
wobei im Speicher (5) die vorgegebene Spannung Ui und die ermittelte Zeit tᵢ und/oder eine Startzeit t_{start_i} gespeichert wird, und
wobei der Mikroprozessor (4) die Folge von wiederkehrenden elektronischen Signalen (10) anhand der Werte im Speicher (5) rekonstruiert und an die Ausgabeeinheit (6) sendet und/oder dort visuell anzeigt.

15. Vorrichtung (1) zur Erzeugung nach Anspruch 14,
**dadurch gekennzeichnet,**
**dass** der Zeit-zu-Digital-Wandler (2) als ein separates Bauteil und/oder als ein FPGA (Field Programmable Gate Array) basierender Zeit-zu-Digital-Wandler (2) ausgebildet ist.

## Claims

1. Method for measuring a sequence of recurring electronic signals (10), wherein the sequence to be measured consists of n recurring electronic signals with i = 1 to n,
wherein a time-to-digital converter (2) and a memory (5), and preferably a microprocessor (4) is provided,
**characterized in that**
a voltage Uᵢ is predetermined for measuring the sequence for an i-th signal of the sequence and a time tᵢ at which the i-th signal (10) has the predetermined voltage Uᵢ is measured using the predetermined voltage Uᵢ, with the steps, preferably in this order:
i) Reading an i-th signal of the sequence into a first channel of the time-to-digital converter (2);
ii) Predetermining an i-th voltage Ui and predetermining a start time t_{start_i} to start a measurement of the i-th signal;
iii) Measurement of the time tᵢ at which the i-th signal has the predetermined voltage Ui ;
iv) Storing the predetermined voltage Ui and the measured time tᵢ, and/or the start time t_{start_i} and the measured time tᵢ, and/or the time difference between the start time t_{start_i} and the measured time tᵢ;
v) Repeating steps i) and iv) with an i+1-th signal (10) and a voltage Uᵢ₊₁, preferably until i + 1 = n or until the predetermined voltage Ui is greater than the maximum voltage Uₘₐₓ of the signal (10);
vi) Reconstructing the recurring electronic signal (10) from the stored measured values of the voltage Ui, the start time t_{start_i} and the time tᵢ;

2. Method according to claim 1,
**characterized in that**
steps i) to iv) are repeated with the same predetermined voltage Uᵢ at an i-th signal (10) for a rising edge and at an i+1-th signal (10) for a falling edge.

3. Method according to claim 1 or 2,
**characterized in that**
the predetermined voltage Uᵢ is increased step by step for each additional i-th measurement, whereby the steps can be constant or non-constant.

4. Method according to any one of claims 1 to 3,
**characterized in that**
the time-to-digital converter (2), preferably in step iii), measures times or a time interval for each Ui, wherein the times are the start time t_{start_i} and/or the measured time tᵢ and the time interval is the difference of the start time t_{start_i} and the measured time tᵢ .

5. Method according to any one of claims 1 to 4,
**characterized in that**
in step iii) for measuring the time tᵢ the predetermined voltage Uᵢ is compared with the i-th signal (10), preferably compared in the time-to-digital converter (2) or in the comparator (3).

6. Method according to any one of claims 1 to 5,
**characterized in that**
the time-to-digital converter (2) determines the time tᵢ by a predetermined voltage threshold which corresponds to the predetermined voltage Ui, or that the time-to-digital converter (2) determines the time tᵢ by a trigger signal of a comparator (3).

7. Method according to any one of claims 1 to 6,
**characterized in that**
the predetermined voltage Uᵢ is predetermined by the time-to-digital converter (2), or that the predetermined voltage Uᵢ is predetermined by a preferably adjustable and/or programmable reference source (9) or by a digital-to-analog converter and is transmitted to the time-to-digital converter (2) or to the comparator (3), preferably that the digital-to-analog converter is arranged in the time-to-digital converter (2) or is arranged in front of the time-to-digital converter (2).

8. Method according to any one of claims 1 to 7,
**characterized in that**
each i-th signal (10) of the sequence is fed into the first channel of the time-to-digital converter (2) and steps i) to vi) are carried out, or
that x time-to-digital converters (2) or one time-to-digital converter (2) with x channels are used in the method and/or are arranged in the device, wherein each of the x time-to-digital converters (2) or channels performs the steps i) to vi), wherein it is preferably provided that x ≤ i applies, wherein for x < i the x time-to-digital converters (2) each perform steps i) to vi) i / x times.

9. Method according to any one of claims 1 to 8,
**characterized in that**
the recurring electronic signal (10) is read directly into the time-to-digital converter (2), or that a filter and/or amplifier and/or signal divider (11) and/or power divider and/or attenuator is arranged in front of the time-to-digital converter (2), and preferably that the signal divider (11) and/or power divider divides the electronic signal (10) into two electronic signals (10) or two signal paths, preferably into a first divided electronic signal (12) and a second divided electronic signal (13).

10. Method according to claim 9,
**characterized in that**
the first divided electronic signal (12) is fed into a first channel of the time-to-digital converter (2) and the second divided electronic signal (13) is fed into a second channel of the time-to-digital converter (2), or the second divided electronic signal (13) is fed into a second time-to-digital converter (2), preferably both the first and the second divided electronic signal (13) are used to measure steps i) to vi), or one of the two signals (12, 13) is used to measure the start time tₛₜₐᵣₜ.

11. The method according to any one of the claims 9 or 10,
**characterized in that**
the first and second divided electronic signal (10) are fed into the first channel of the time-to-digital converter (2) by delaying the second divided electronic signal (13), preferably the start time tₛₜₐᵣₜ and the measured time tᵢ of the signal (10) or the time difference tᵢ - tₛₜₐᵣₜ are stored.

12. Method according to any one of claims 1 to 11,
**characterized in that**
in step ii) a start time tₛₜₐᵣₜ is predetermined by a start signal, preferably that the start signal is predetermined by the time-to-digital converter (2) or by an external clock, or preferably that the start signal is a further input signal of a start signal channel, preferably generated by an external clock or by the signal divider (11) and/or power divider, or is a start signal which is generated and/or defined internally in the device, preferably by the microprocessor (4) or a clock generator or another electronic component.

13. Method according to any one of claims 1 to 12,
**characterized in that**
steps i) to iv) are repeated at the same voltage Uᵢ for several signals (10) j, preferably repeated before step v), preferably repeated j times in order to measure the times tᵢⱼ , wherein j = 1 to m with integer j applies.

14. A device (1) for measuring a sequence of recurring electronic signals, the device comprising a time-to-digital converter (2) (TDC), a microprocessor (4) connected thereto, a memory (5) writable by the microprocessor (4) and/or the time-to-digital converter (2) (TDC), a comparator (3) arranged in or connected to the time-to-digital converter (2) (TDC) and an output unit (6),
**characterized in that**
the comparator (3) measures whether the signal sequence of recurring electronic signals (10) has the predetermined voltage Uᵢ and the time-to-digital converter (2) determines a time tᵢ at which the signal sequence has the predetermined voltage Ui, and
wherein the predetermined voltage Uᵢ and the determined time tᵢ and/or a start time t_{start_i} are stored in the memory (5), and
wherein the microprocessor (4) reconstructs the sequence of recurring electronic signals (10) on the basis of the values in the memory (5) and sends it to the output unit (6) and/or displays it there visually.

15. Device (1) for generation according to claim 14,
**characterized in that**
the time-to-digital converter (2) is designed as a separate component and/or as an FPGA (Field Programmable Gate Array) based time-to-digital converter (2).

## Revendications

1. Procédé de mesure d'une séquence de signaux électroniques répétitifs (10), la séquence à mesurer étant constituée de n signaux électroniques répétitifs avec i = 1 à n,
dans lequel un convertisseur temps-numérique (2) et une mémoire (5), et de préférence un microprocesseur (4), sont fournis,
**caractérisé en ce que**
une tension Uᵢ est prédéfinie pour mesurer la séquence pour un i-ième signal de la séquence et un temps tᵢ est mesuré à l'aide de la tension prédéfinie Uᵢ , pendant lequel le i-ième signal (10) présente la tension prédéfinie Uᵢ , avec les étapes, de préférence dans cet ordre :
i) lire un i-ième signal de la séquence dans un premier canal du convertisseur temps-numérique (2) ;
ii) définition d'une i-ième tension Uᵢ et définition d'un temps de démarrage t_{start_i} pour démarrer une mesure du i-ième signal ;
iii) mesure du temps tᵢ auquel le i-ième signal présente la tension prédéterminée Uᵢ ;
iv) mémoriser la tension prédéterminée Uᵢ et le temps mesuré tᵢ, et/ou le temps de démarrage t_{start_i} et le temps mesuré tᵢ, et/ou la différence de temps entre le temps de démarrage t_{start_i} et le temps mesuré tᵢ,
v) répétition des étapes i) et iv) avec un i+1-ième signal (10) et une tension Uᵢ₊₁, de préférence jusqu'à ce que i + 1 = n soit valable ou jusqu'à ce que la tension prédéterminée Uᵢ soit supérieure à la tension maximale Uₘₐₓ du signal (10) ;
vi) reconstruire le signal électronique répétitif (10) à partir des valeurs de mesure mémorisées de la tension Uᵢ, du temps de démarrage t_{start_i} et du temps tᵢ;

2. Procédé selon la revendication 1,
**caractérisé en ce que**
les étapes i) à iv) sont répétées avec la même tension prédéterminée Uᵢ pour un i-ième signal (10) pour un front croissant et pour un i+1-ième signal (10) pour un front décroissant.

3. Procédé selon la revendication 1 ou 2,
**caractérisé en ce que**
la tension prédéterminée Uᵢ est augmentée par pas pour chaque i-ième mesure supplémentaire, les pas pouvant être constants ou non.

4. Procédé selon l'une quelconque des revendications 1 à 3,
**caractérisé en ce que**
le convertisseur temps-numérique (2) mesure, de préférence à l'étape iii), des temps ou un intervalle de temps pour chaque Ui, les temps étant le temps de démarrage t_{start_i} et/ou le temps mesuré tᵢ et l'intervalle de temps étant la différence entre le temps de démarrage t_{start_i} et le temps mesuré tᵢ .

5. Procédé selon l'une quelconque des revendications 1 à 4,
**caractérisé en ce que**
à l'étape iii), pour mesurer le temps tᵢ, la tension prédéterminée Uᵢ est comparée au i-ième signal (10), de préférence dans le convertisseur temps-numérique (2) ou dans le comparateur (3).

6. Procédé selon l'une quelconque des revendications 1 à 5,
**caractérisé en ce que**
le convertisseur temps-numérique (2) détermine le temps tᵢ par un seuil de tension prédéterminé qui correspond à la tension prédéterminée Uᵢ , ou que le convertisseur temps-numérique (2) détermine le temps tᵢ par un signal de déclenchement d'un comparateur (3).

7. Procédé selon l'une quelconque des revendications 1 à 6,
**caractérisé en ce que**
la tension prédéterminée Uᵢ est prédéterminée par le convertisseur temps-numérique (2), ou que la tension prédéterminée Uᵢ est prédéterminée par une source de référence (9) de préférence réglable et/ou programmable ou par un convertisseur numérique-analogique et est transmise au convertisseur temps-numérique (2) ou au comparateur (3), de préférence que le convertisseur numérique-analogique est disposé dans le convertisseur temps-numérique (2) ou est disposé avant le convertisseur temps-numérique (2).

8. Procédé selon l'une quelconque des revendications 1 à 7,
**caractérisé en ce que**
chaque i-ième signal (10) de la séquence est injecté dans le premier canal du convertisseur temps-numérique (2) et les étapes i) à vi) sont exécutées, ou x convertisseurs temps-numérique (2) ou un convertisseur temps-numérique (2) avec x canaux sont utilisés dans le procédé et/ou sont disposés dans le dispositif, chacun des x convertisseurs temps-numérique (2) ou canaux exécutant les étapes i) à vi), de préférence étant prévu que x ≤ i, où pour x < i les x convertisseurs temps-numérique (2) exécutent respectivement les étapes i) à vi) i / x fois.

9. Procédé selon l'une quelconque des revendications 1 à 8,
**caractérisé en ce que**
le signal électronique récurrent (10) est lu directement dans le convertisseur temps-numérique (2), ou **en ce qu'**un filtre et/ou un amplificateur et/ou un diviseur de signal (11) et/ou un diviseur de puissance et/ou un atténuateur est disposé avant le convertisseur temps-numérique (2), et de préférence **en ce que** le diviseur de signal (11) et/ou le diviseur de puissance divise le signal électronique (10) en deux signaux électroniques (10) ou deux chemins du signal, de préférence en un premier signal électronique divisé (12) et un deuxième signal électronique divisé (13).

10. Procédé selon la revendication 9,
**caractérisé en ce que**
le premier signal électronique divisé (12) est injecté dans un premier canal du convertisseur temps-numérique (2) et le deuxième signal électronique divisé (13) est injecté dans un deuxième canal du convertisseur temps-numérique (2), ou le deuxième signal électronique divisé (13) est injecté dans un deuxième convertisseur temps-numérique (2), de préférence les deux premier et deuxième signaux électroniques divisés (13) sont utilisés pour mesurer les étapes i) à vi), ou l'un des deux signaux (12, 13) est utilisé pour mesurer le temps de démarrage tₛₜₐᵣₜ.

11. Procédé selon l'une des revendications 9 ou 10,
**caractérisé en ce que**
le premier et le deuxième signal électronique divisé (10) sont injectés dans le premier canal du convertisseur temps-numérique (2) en retardant le deuxième signal électronique divisé (13), de préférence, le temps de démarrage tₛₜₐᵣₜ et le temps mesurée tᵢ du signal (10) ou la différence de temps tᵢ - tₛₜₐᵣₜ sont enregistrées.

12. Procédé selon l'une quelconque des revendications 1 à 11,
**caractérisé en ce que**
à l'étape ii), la spécification d'un temps de démarrage tₛₜₐᵣₜ est effectuée par un signal de démarrage, de préférence que le signal de démarrage est spécifié par le convertisseur temps-numérique (2) ou une horloge externe, ou de préférence que le signal de démarrage est un autre signal d'entrée d'un canal de signal de démarrage, de préférence généré par une horloge externe ou par le diviseur de signal (11) et/ou le diviseur de puissance, ou est un signal de démarrage qui est généré et/ou défini de manière interne dans le dispositif, de préférence par le microprocesseur (4) ou une horloge ou un autre composant électronique.

13. Procédé selon l'une quelconque des revendications 1 à 12,
**caractérisé en ce que**
les étapes i) à iv) sont répétées pour une même tension Uᵢ pour plusieurs signaux (10) j, de préférence sont répétées avant l'étape v), de préférence sont répétées j fois, pour mesurer les temps tᵢⱼ , où j = 1 à m avec j entier.

14. Dispositif (1) pour la mesure d'une séquence de signaux électroniques répétitifs, le dispositif comprenant un convertisseur temps-numérique (2) (TDC), un microprocesseur (4) relié à celui-ci, une mémoire (5) inscriptible par le microprocesseur (4) et/ou le convertisseur temps-numérique (2) (TDC), un comparateur (3) disposé dans le convertisseur temps-numérique (2) (TDC) ou relié à celui-ci et une unité de sortie (6),
**caractérisé en ce que**
le comparateur (3) mesure si la séquence de signaux constituée de signaux électroniques répétitifs (10) présente la tension prédéterminée Uᵢ et le convertisseur temps-numérique (2) détermine un temps tᵢ auquel la séquence de signaux présente la tension prédéterminée Uᵢ , et
dans lequel la tension prédéterminée Uᵢ et le temps déterminé tᵢ et/ou un temps de démarrage t_{start_i} sont enregistrés dans la mémoire (5), et dans lequel le microprocesseur (4) reconstruit la séquence de signaux électroniques répétitifs (10) à l'aide des valeurs dans la mémoire (5) et l'envoie à l'unité de sortie (6) et/ou l'y affiche visuellement.

15. Dispositif (1) de génération selon la revendication 14,
**caractérisé en ce que**
le convertisseur temps-numérique (2) est réalisé sous la forme d'un composant séparé et/ou d'un convertisseur temps-numérique (2) basé sur un FPGA (Field Programmable Gate Array).
